# EUROPÄISCHE PATENTSCHRIFT

(11) **EP 0 507 059 B1**
(45) Veröffentlichungstag und Bekanntmachung des Hinweises auf die Patenterteilung: **29.11.1995**
(21) Anmeldenummer: 92101922.0
(22) Anmeldetag: 05.02.1992
(51) Int. Cl.: H05K 5/02

(54) **Verriegelungsanordnung für Baugruppen**
Locking device for components
Dispositif de verrouillage pour ensembles en pièces détachées

(30) Priorität: 04.04.1991 DE 4110924
(43) Veröffentlichungstag der Anmeldung: 07.10.1992
(73) Patentinhaber: SCHLEICHER ELECTRONIC GMBH & CO. KG, D-85764 Oberschleissheim (DE)
(72) Erfinder: Lichtensperger, Ernst, W-8057 Eching (DE); Schropp, Klaus, W-8961 Sulzberg-Graben (DE)
(74) Vertreter: Pfenning, Meinig & Partner

(56) Entgegenhaltungen:
- DE-A- 2 213 706
- DE-A- 2 321 069
- DE-A- 2 948 354
- DE-A- 3 038 719
- DE-A- 3 310 474

## Beschreibung

Die Erfindung betrifft eine Verriegelungsanordnung für Baugruppen für Meß-, Regel-, Steuerungs- und Prozeßfunktionen aller Art nach dem Oberbegriff des Hauptanspruchs.

Für Steuerungen, Regelungen, Schalteinrichtungen und Relaisanordnungen werden zunehmend Baugruppen verwendet, die kundenspezifisch in ihrem Aufbau an die jeweiligen Prozeßaufgaben angepaßt werden können. Dabei bestehen die Baugruppen aus jeweils einem Gehäuserahmen, in die Module von vorne eingeschoben und arretiert werden. Dabei werden eine Mehrzahl von Gehäuserahmen mit Modulen nebeneinanderliegend auf Schienen befestigt, die beispielsweise in Schaltschränken angeordnet sind. Für eine elektrische Verbindung ist ein Bussystem vorgesehen, das durch die Baugruppen durchgeschleift wird, wobei in den Seitenwänden der Gehäuserahmen Steckervorrichtungen eingesetzt sind, die bei Aneinanderreihung der Baugruppen ineinandergesteckt werden. Zur Arretierung der Gesamtheit der Baugruppen ist es bekannt, Klemmstücke vorzusehen, die auf die Schienen aufgesetzt sind und jeweils seitlich gegen die letzten Baugruppen drücken.

Es hat sich gezeigt, daß eine derartige Verriegelung nicht ausreichend ist, da sich durch Vibrationen oder auch während des Transports von Schaltschränken die Baugruppen und somit die Steckervorrichtungen für die elektrische Verbindung voneinander gelöst haben und durch Wiedereinstecken falsche Verbindungen auftraten. Es wurde daher das Bussystem gestört, wodurch auch das Gesamtsystem nicht mehr richtig arbeitete. Der Erfindung liegt somit die Aufgabe zugrunde, eine Verriegelungsanordnung für Baugruppen gemäß dem Oberbegriff des Hauptanspruchs zu schaffen, die eine einfache und sichere Verbindung zwischen den Gehäuserahmen der einzelnen Baugruppen ermöglicht und auch bei mechanischen Beanspruchungen aufrecht erhält, derart, daß das über Steckervorrichtungen geführte Bussystem sauber und zuverlässig arbeiten kann.

Diese Aufgabe wird erfindungsgemäß durch die kennzeichnenden Merkmale des Hauptanspruchs gelöst.

Dadurch, daß in den Seitenwänden der Gehäuserahmen Öffnungen vorgesehen sind, und daß weiterhin mit diesen Öffnungen fluchtende Zapfen an den Seitenwänden angeformt sind, greifen die Zapfen beim Aneinanderreihen von Baugruppen in die entsprechenden Öffnungen ein. Zur Arretierung ist ein in der Seitenwand geführter Federriegel vorgesehen, der in eine am Zapfen angeordnete Hinterschneidung eingreift. Auf diese Weise wird eine formschlüssige Verbindung zur Verfügung gestellt, die dauerhaft bestehen bleibt.

Durch die in den Unteransprüchen angegebenen Maßnahmen sind vorteilhafte Weiterbildungen und Verbesserungen möglich. Besonders vorteilhaft ist, daß der Federriegel mit einem länglichen Durchbruch ausgebildet ist, in dem eine Feder liegt, die vorzugsweise integraler Bestandteil des Federriegels ist. Dadurch wird der Federriegel unter Vorspannung in dem verriegelten Zustand gehalten. Weiterhin kann durch Vorsehen einer Schräge am Zapfen und ebenfalls am unteren Ende des Federriegels die Herstellung der Verriegelung in einfacher Weise gestaltet werden, da beim Einführen des Zapfens in die Öffnung dieser den Federriegel unter Ausnützung der Schrägen hochhebt, so daß dieser in die Hinterschneidung einschnappen kann. Weiterhin ist vorteilhaft, daß an dem Federriegel Rastnasen und an der Seitenwand Rastausnehmungen vorgesehen sind, da der Federriegel durch Verrastung dann in seiner angehobenen Stellung festgehalten werden kann.

Ein Ausführungsbeispiel der Erfindung ist in der Zeichnung dargestellt und wird in der nachfolgenden Beschreibung näher erläutert. Es zeigen:
- Fig. 1: einen Schnitt durch die Seitenwände zweier aneinanderliegender Gehäuserahmen mit Federriegel und Zapfen,
- Fig. 2: eine Aufsicht auf den Federriegel mit Zapfen in ihrer verriegelten Stellung, wobei die Schnittlinien I-I den Schnitt entsprechend Fig. 1 andeuten,
- Fig. 3: die Ansicht des Federriegels und des Zapfens beim Verriegeln, und
- Fig. 4: die Ansicht des Federriegels und des Zapfens im angehobenen Zustand des Federriegels.

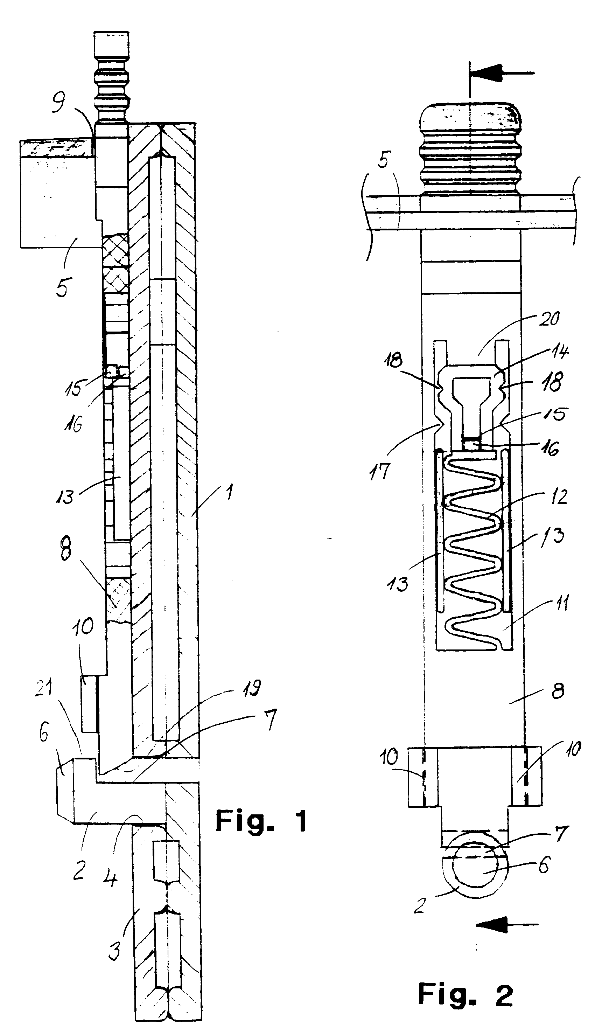

In Fig. 1 ist ein Schnitt durch die Verriegelungsanordnung und in Fig. 2 eine Aufsicht dargestellt, wobei der Gehäuserahmen nur andeutungsweise vorgesehen ist. In Fig. 1 ist mit 1 die Seitenwand eines Gehäuserahmens bezeichnet, an der ein Zapfen 2 angeformt ist. Die Seitenwand 3 des danebenliegenden Gehäuserahmens weist eine Öffnung 4 auf, wobei die Fortsetzung des Gehäuserahmens durch den Ansatz 5 dargestellt wird. Der Zapfen 2 ist mit einem konusförmigen Ansatz 6 versehen und weist eine Hinterschneidung 7 auf. Oberhalb des Zapfens ist ein flacher zungenförmiger Federriegel 8 angeordnet, der durch eine Öffnung 9 im Gehäuserahmen bzw. in dem Ansatz 5 hindurchgreift und an seinem unteren Ende in zwei an der Seitenwand 3 angeformten Führungen 10 geführt ist.

Der zungenförmige Federriegel 8 weist einen länglichen Durchbruch 11 auf, wobei in dem Durchbruch 11 eine zickzackförmige Feder 12 angeordnet ist, die integraler Bestandteil des Federriegels 8 ist und zusammen mit diesem aus einem Kunststoff gespritzt ist. In den länglichen Durchbruch 11 greifen zwei parallele, an der Seitenwand des Gehäuserahmens angeformte Stege 13 ein, die an den Seitenflächen des Durchbruchs 11 anliegen und zwischen denen die Feder 12 geführt ist. Darüber hinaus greift in den Durchbruch 11 noch ein an der Seitenwand angeformter Vorsprung 14 ein, der ein Gegenlager für die Feder 12 bildet und gleichzeitig als Anschlag für den Federriegel im verriegelten Zustand dient. Der Vorsprung 14 weist eine Ausnehmung 15 auf, in die ein an dem freien Ende der Feder 12 angeformter Ansatz 16 eingreift, wodurch die Feder arretiert wird. Weiterhin sind an den Federriegel 8 Rastnasen 17 angeordnet, die in den Durchbruch 11 hineinragen und mit Rastausnehmungen 18 zusammenarbeiten, die an dem Vorsprung 14 vorgesehen sind.

Der Federriegel 8 ist an seinem unteren Ende mit einer, der Seitenwand 3 zugewandten Schräge 19 versehen.

Beim Einbau des Federriegels 8 in die Seitenwand, wird dieser durch die Öffnung 9 hindurchgeführt und aufgrund seiner Elastizität über die Stege 13 und den Vorsprung 14 herübergebogen und mit seinem unteren Ende in die Führungen 10 eingeschoben, wobei anschließend die Stege 13 in den Durchbruch 11 eingreifen und der Ansatz 16 der Feder 12 in der Ausnehmung 15 aufgenommen wird. Das obere Ende 20 des Durchbruchs 11 liegt dabei als Anschlag am Vorsprung 14 an. In diesem Zustand weist die Feder eine geringe Vorspannung auf, im Ausführungsbeispiel ist sie etwa um 2 mm zusammengedrückt.

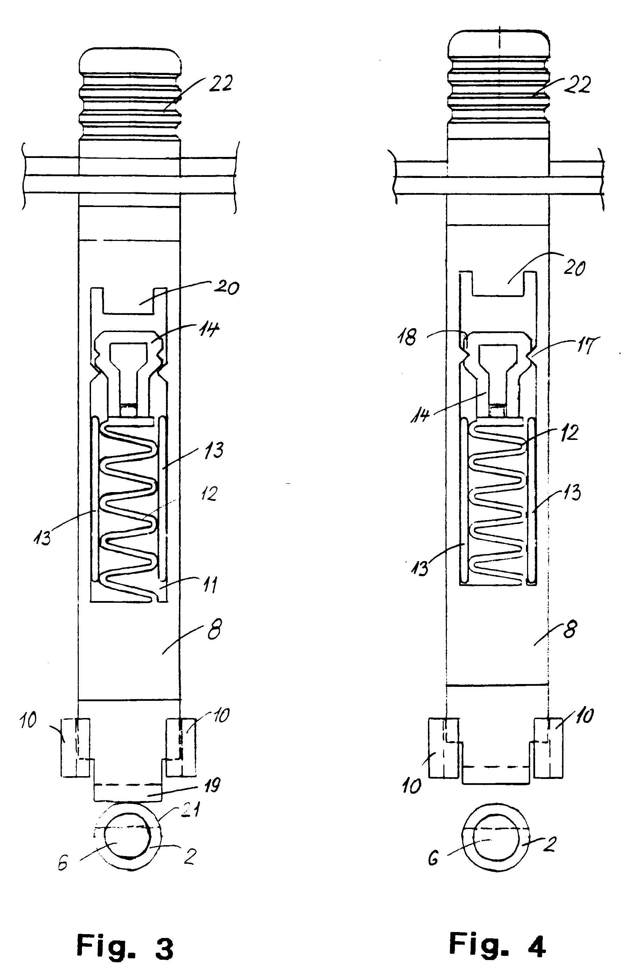

In Fig. 3 wird der Zustand des Federriegels beim Verriegeln gezeigt. Wenn der Zapfen durch die Öffnung in der Seitenwand durchgeschoben wird, trifft der konusförmige Ansatz 6 des Zapfens auf die Schräge 19 am unteren Ende des Federriegels 8. Der Zapfen wird weiter eingeschoben und der Federriegel 8 wird unter Mithilfe des konusförmigen Ansatzes 6 und der Schräge 19 angehoben bis er, wie in Fig. 3 gezeigt, auf dem zylindrischen Teil 21 des Zapfens 2 aufliegt. Dabei wird die Feder um ca. weitere 2 mm zusammengedrückt. Das untere Ende des Federriegels gleitet auf den zylindrischen Teil 21 des Zapfens 2 entlang, bis die Hinterschneidung 7 kommt und der Federriegel 8 aufgrund der Vorspannkraft der Feder 12 in die Hinterschneidung 7 springt. Dabei wird die Bewegung nach unten durch das auf den Vorsprung 14 treffende Ende 20 der Durchbrechung 11 gebremst.

Zum Lösen der Verriegelung wird das aus dem Gehäuserahmen herausragende Ende 22 des Federriegels 8, wie aus Fig. 4 erkennbar, gegen die Federkraft der Feder 12 hochgezogen, bis die Stege 13, die gleichfalls als Anschlag dienen, gegen das untere Ende des Durchbruchs 11 stoßen. Gleichzeitig greifen die Rastnasen 17 in die Rastausnehmungen 18 im Vorsprung 14 ein und stellen so den Federriegel 8 fest. Dabei ist die form- und kraftschlüssige Verbindung zwischen Rastnasen 17 und Rastausnehmungen 18 so bemessen, daß sie etwas größer ist als die durch die zusammengedrückte Feder vorgegebene Federkraft. Damit zu erkennen ist, daß sich der Federriegel 8 in seinem entriegelten Zustand befindet, ist am oberen Teil 22 des Federriegels 8 eine Markierung angebracht, die dann zu sehen ist, wenn der Federriegel 8 entriegelt ist.

## Patentansprüche

1. Verriegelungsanordnung für Baugruppen für Meß-, Regel-, Steuerungs- und Prozeßfunktionen aller Art, die aus einer Mehrzahl von Module aufnehmenden Gehäuserahmen bestehen, wobei die Gehäuserahmen nebeneinanderliegend an Schienen befestigt sind und die elektrische Verbindung entsprechend einem Bussystem über an den Gehäuserahmen seitlich angeordnete Steckervorrichtungen hindurchgeführt wird,
**dadurch gekennzeichnet**,
daß in den Seitenwänden (1, 3) der Gehäuserahmen Öffnungen (4) vorgesehen sind und an den Seitenwänden (1, 3) Zapfen (2) mit Hinterschneidungen (7) angeformt sind, wobei die Zapfen (2) die entsprechenden Öffnungen (4) durchgreifen, wenn die Gehäuserahmen nebeneinanderliegend auf den Schienen angeordnet sind, und daß jeder Öffnung-Zapfen-Verbindung ein Federriegel (8) zugeordnet ist, der in der Seitenwand (3) geführt ist und unter leichter Vorspannung die Hinterschneidung (7) hintergreift.

2. Verriegelungsanordnung nach Anspruch 1, dadurch gekennzeichnet, daß der Federriegel (8) länglich ausgebildet ist und einen länglichen Durchbruch (11) aufweist, in die eine Feder (12) eingesetzt ist, die sich einerseits am Federriegel (8) selbst und andererseits an einem Vorsprung (14) an der Seitenwand (3) des Gehäuserahmens abstützt.

3. Verriegelungsanordnung nach Anspruch 1 oder 2, dadurch gekennzeichnet, daß die Feder (12) einstückig mit dem Federriegel (8) verbunden ist und Feder (12) und Federriegel (8) aus Kunststoff bestehen.

4. Verriegelungsanordnung nach einem der Ansprüche 1 bis 3, dadurch gekennzeichnet, daß in den Durchbruch (11) im Federriegel (8) zwei an der Seitenwand (3) angeformte Längsstege (13) eingreifen, zwischen denen die Feder (12) geführt ist.

5. Verriegelungsanordnung nach einem der Ansprüche 1 bis 4, dadurch gekennzeichnet, daß die Feder (12) an ihrem einen Ende einen Ansatz (16) aufweist, der zur Festlegung der Feder (12) in eine in den Vorsprung (14) an der Seitenwand (3) vorgesehene Ausnehmung (15) eingreift.

6. Verriegelungsanordnung nach einem der Ansprüche 1 bis 5, dadurch gekennzeichnet, daß der Zapfen (2) einen konusförmigen Ansatz (6) und der Federriegel (8) an seinem unteren Ende eine Schräge (19) aufweisen, wobei beim Einführen des Zapfens (2) in die Öffnung (4) der konusförmige Ansatz (6) an der Schräge (19) entlang läuft und dabei den Federriegel (8) gegen die Federkraft anhebt, der bei weiterer Bewegung des Zapfens (2) durch die Öffnung (4) in die Hinterschneidung (7) schnappt.

7. Verriegelungsanordnung nach einem der Ansprüche 1 bis 6, dadurch gekennzeichnet, daß zum Lösen der Verriegelung der Federriegel (8) gegen die Federkraft angehoben wird, wobei die Längsstege (13) im Durchbruch (11) des Federriegels (8) einen Anschlag bilden.

8. Verriegelungsanordnung nach einem der Ansprüche 1 bis 7, dadurch gekennzeichnet, daß an den Federriegel (8) Rastnasen (17) angeformt sind, die in den Durchbruch (11) ragen, und daß an dem Vorsprung (14) Rastausnehmungen (18) vorgesehen sind, wobei zur Feststellung des angehobenen Federriegels (8) die Rastnasen (17) in die Rastausnehmungen (18) eingreifen.

## Claims

1. A locking device for assembly groups for measuring, regulating, control and procedural functions of all kinds, comprising a housing frame which accommodates a plurality of modules, in which respect the housing frames are attached side by side to tracks, and the electrical connection passes, to correspond with a bus system, through socket devices which are arranged laterally on the housing frame, **characterized in that** in the side walls (1, 3) of the housing frames are provided openings (4), and pins (2) with undercuts (7) are integrated at the side walls (1, 3), and that the pins (2) pass through the respective openings (4), when the housing frames are arranged side by side on the tracks, and that each opening-to-pin connection is associated with a spring lock (8), which is guided in the side wall (3) and which reaches under slight pretensioning behind the undercut (7).

2. A locking arrangement according to claim 1, **characterized in that** the spring lock (8) is of longitudinal design and comprises an oblong passage (11) into which is inserted a spring (12) which supports itself on the one side against the spring lock (8) itself and on the other side against a protrusion (14) on the side wall (3) of the housing frame.

3. A locking arrangement according to claim 1 or 2, **characterized in that** the spring (12) is integrated into the spring lock (8), and spring (12) and spring lock (8) are made of a plastic material.

4. A locking arrangement according to one of claims 1 to 3, **characterized in that** two longitudinal webs (13), which are formed onto the side wall (3) and between which the spring (12) is guided, engage the passage (11) in the spring lock (8).

5. A locking arrangement according to one of claims 1 to 4, **characterized in that** the spring (12) has at its one end an extension (16) which engages a cutout (15) provided in the protrusion (14) on the side wall (3) for the purpose of fixing the spring (12).

6. A locking arrangement according to one of claims 1 to 5, **characterized in that** the pin (2) comprises a conical extension (6), and the spring lock (8) comprises at its lower end a slant (19), and that on insertion of the pin (2) into the opening (4) the conical protrusion (6) moves along the slant (19) whilst lifting the spring lock (8) against the load of the spring which, with continued movement of the pin (2) through the opening (4), snaps into the undercut (7).

7. A locking arrangement according to one of claims 1 to 6, **characterized in that**, for the purpose of releasing the lock, the spring lock (8) is lifted against the springload, and that the longitudinal webs (13) form a stop in the passage (11) of the spring lock (8).

8. A locking arrangement according to one of claims 1 to 7, **characterized in that** integrated into the spring lock (8) are detent hooks (17) which protrude into the passage (11), and that detent cutouts (18) are provided on the protrusion (14), and that the detent hooks (17) engage the detent cutouts (18) for the purpose of fixing the raised spring lock (8).

## Revendications

1. Dispositif de verrouillage pour des modules utilisés pour des fonctions de mesure, de régulation, de commande et d'exécution de processus de tous types, qui sont constitués par une multiplicité de cadres de boîtier logeant des modules, les cadres de boîtier étant fixés côte-à-côte sur des rails, tandis que la liaison électrique est établie, conformément à un système de bus, par l'intermédiaire de dispositifs à enfichage disposés latéralement sur les cadres de boîtier,
caractérisé en ce
que des ouvertures (4) sont prévues dans les parois latérales (1,3) des cadres de boîtier et des tétons (2) comportant des parties en dépouille (7) étant formés sur les parois latérales (1,3), les tétons (2) traversant les ouvertures correspondantes (4) lorsque les cadres de boîtier sont disposés côte-à-côte sur les rails, et ce que chaque liaison ouverture - téton est associé un verrou à ressort (8), qui est guidé dans la paroi latérale (3) et s'engage sous une faible précontrainte derrière la partie en dépouille (7).

2. Dispositif de verrouillage selon la revendication 1, caractérisé en ce que le verrou à ressort (8) possède une forme allongée et comporte un passage longitudinal (11), dans lequel est inséré un ressort (12) qui prend appui d'une part sur le verrou à ressort (8) lui-même et d'autre part sur un appendice saillant (14) présent sur la paroi latérale (3) du cadre de boîtier.

3. Dispositif de verrouillage selon la revendication 1 ou 2, caractérisé en ce que le ressort (12) est relié d'un seul tenant au verrou à ressort (8), le ressort (12) et le verrou à ressort (8) étant réalisés en matière plastique.

4. Dispositif de verrouillage selon l'une des revendications 1 à 3, caractérisé en ce que dans le passage (11) ménagé dans le verrou à ressort (8) s'engagent deux barrettes longitudinales (13) formées par moulage sur la paroi latérale (3) et entre lesquelles le ressort (12) est guidé.

5. Dispositif de verrouillage selon l'une des revendications 1 à 4, caractérisé en ce que le ressort (12) possède, au niveau de l'une de ses extrémités, un élément saillant (16), qui, pour la fixation du ressort (12), s'engage dans un évidement (15) prévu dans l'appendice saillant (14), au niveau de la paroi latérale (3).

6. Dispositif de verrouillage selon l'une des revendications 1 à 5, caractérisé en ce que le téton (2) possède un élément saillant de forme conique (6) et le verrou à ressort (8) possède un biseau (19) au niveau de son extrémité inférieure, auquel cas lors de l'introduction du téton (2) dans l'ouverture (4), l'élément saillant de forme conique (6) glisse le long du biseau (19) et écarte, à l'encontre de la force du ressort, le verrou à ressort (8), qui, lors de la poursuite du déplacement du téton (2) à travers l'ouverture (4), s'encliquette dans la partie en dépouille (7).

7. Dispositif de verrouillage selon l'une des revendications 1 à 6, caractérisé en ce que pour supprimer le verrouillage, on écarte le verrou à ressort (8) à l'encontre de la force du ressort, les barrettes longitudinales (13) formant une butée dans le passage (11) du verrou à ressort (8).

8. Dispositif de verrouillage selon l'une des revendications 1 à 7, caractérisé en ce que sur le verrou à ressort (8) sont formés par moulage des becs d'encliquetage (17), qui s'engagent dans le passage (11), et en ce que des évidements d'encliquetage (18) sont prévus sur l'appendice saillant (14), les becs d'encliquetage (17) s'engageant dans les évidements d'encliquetage (18) pour la fixation du verrou à ressort soulevé (8).
